# EUROPEAN PATENT APPLICATION

(11) **EP 2 296 193 A2**
(43) Date of publication of application: **16.03.2011**
(21) Application number: 10176185.6
(22) Date of filing: 10.09.2010
(51) Int. Cl.: H01L 31/18, H01L 31/075, H01L 27/142

(54) **Photovoltaic device and method for manufacturing the same**

(30) Priority: 11.09.2009 KR 20090085718
(71) Applicant: KISCO, Changwon-si Gyeongsangnam-do 641-370 (KR)
(72) Inventor: Myong, Seung-Yeop, 156-831, Seoul (KR)
(74) Representative: Ferreccio, Rinaldo

(57) **Abstract**

Disclosed is a method for manufacturing a photovoltaic device. The method includes: forming a first electrode on a substrate; forming a first unit cell on the first electrode, the first unit cell comprising an intrinsic semiconductor layer; forming an intermediate reflector on the first unit cell, the intermediate reflector comprises a plurality of sub-layers stacked alternately by modulating the applied voltages in accordance with time, the applied voltages exciting plasma and having mutually different frequencies; forming a second unit cell on the intermediate reflector, the second unit cell comprising an intrinsic semiconductor layer; and forming a second electrode on the second unit cell.

## Description

### Field

This embodiment relates to a photovoltaic device and a method for manufacturing the same.

### Description of the Related Art

Recently, because of a high oil price and a global warming phenomenon based on a large amount of CO₂ emission, energy is becoming the most important issue in determining the future life of mankind. Even though many technologies using renewable energy sources including wind force, bio-fuels, a hydrogen/fuel cell and the like have been developed, a photovoltaic device using sunlight is in the spotlight in that solar energy, the origin of all energies, is an almost infinite clean energy source.

The sunlight incident on the surface of the earth has an electric power of 120,000 TW. Thus, theoretically, if a photovoltaic device having a photoelectric conversion efficiency of 10% covers only 0.16% of the land surface of the earth, it is possible to generate electric power of 20 TW that is twice as much as the amount of energy globally consumed during one year.

Practically, the world photovoltaic market has explosively grown by almost 40% of an annual growth rate for the last ten years. Now, a bulk-type silicon photovoltaic device occupies a 90% of the photovoltaic device market share. The bulk-type silicon photovoltaic device includes a single-crystalline silicon photovoltaic device and multi-crystalline or poly-crystalline silicon photovoltaic device and the like. However, productivity of a solar-grade silicon wafer which is the main material of the photovoltaic device is not able to fill the explosive demand thereof, so the solar-grade silicon wafer is globally in short supply. Therefore, this shortage of the solar-grade silicon wafer is a huge threatening factor in reducing the manufacturing cost of a photovoltaic device.

Contrary to this, a thin-film silicon photovoltaic device including a light absorbing layer based on a hydrogenated amorphous silicon (a-Si:H) allows to reduce a thickness of a silicon layer equal to or less than 1/100 as large as that of a silicon wafer of the bulk-type silicon photovoltaic device. Also, it makes possible to manufacture a large area photovoltaic device at a lower cost.

Meanwhile, a single-junction thin-film silicon photovoltaic device is limited in its achievable performance. Accordingly, a double junction thin-film silicon photovoltaic device or triple junction thin-film silicon photovoltaic device having a plurality of stacked unit cells has been developed, pursuing high stabilized efficiency.

The double junction or triple junction thin-film silicon photovoltaic device is referred to as a tandem-type photovoltaic device. The open circuit voltage of the tandem-type photovoltaic device corresponds to a sum of each unit cell's open circuit voltage. Short circuit current is determined by a minimum value among the short circuit currents of the unit cells.

Regarding the tandem-type photovoltaic device, research is being devoted to an intermediate reflector which is capable of improving efficiency by enhancing internal light reflection between the unit cells.

### Summary

One aspect of this invention is a method for manufacturing a photovoltaic device. The method includes: forming a first electrode on a substrate; forming a first unit cell on the first electrode, the first unit cell comprising an intrinsic semiconductor layer; forming an intermediate reflector on the first unit cell, the intermediate reflector comprises a plurality of sub-layers stacked alternately by modulating the applied voltages in accordance with time, the applied voltages exciting plasma and having mutually different frequencies; forming a second unit cell on the intermediate reflector, the second unit cell comprising an intrinsic semiconductor layer; and forming a second electrode on the second unit cell.

Another aspect of this invention is a photovoltaic device. The device comprises: a substrate; a first electrode placed on the substrate; a first unit cell placed on the first electrode and comprising an intrinsic semiconductor layer; an intermediate reflector placed on the first unit cell, and comprising a plurality of sub-layers stacked alternately and having different crystal volume fractions from each other by modulating the applied voltages in accordance with time, the applied voltages exciting plasma and having mutually different frequencies; a second unit cell placed on the intermediate reflector and comprising an intrinsic semiconductor layer; and a second electrode placed on the second unit cell.

### Brief description of the drawings

Figs. 1a to 1g show a method for manufacturing a photovoltaic device according to an embodiment of the present invention.
Fig. 2 shows a plasma-enhanced chemical vapor deposition apparatus for forming an intermediate reflector in accordance with the embodiment of the present invention.
Figs. 3 and 4 show frequency variations of a first power source and second power source which are supplied to a reaction chamber so as to form the intermediate reflector in accordance with the embodiment of the present invention.
Fig. 5 shows the intermediate reflector included in the embodiment of the present invention.
Fig. 6 shows a photovoltaic device according to another embodiment of the present invention.

### Detailed description of embodiments

A method for manufacturing a photovoltaic device according to an embodiment of the present invention will be described with reference to the drawings.

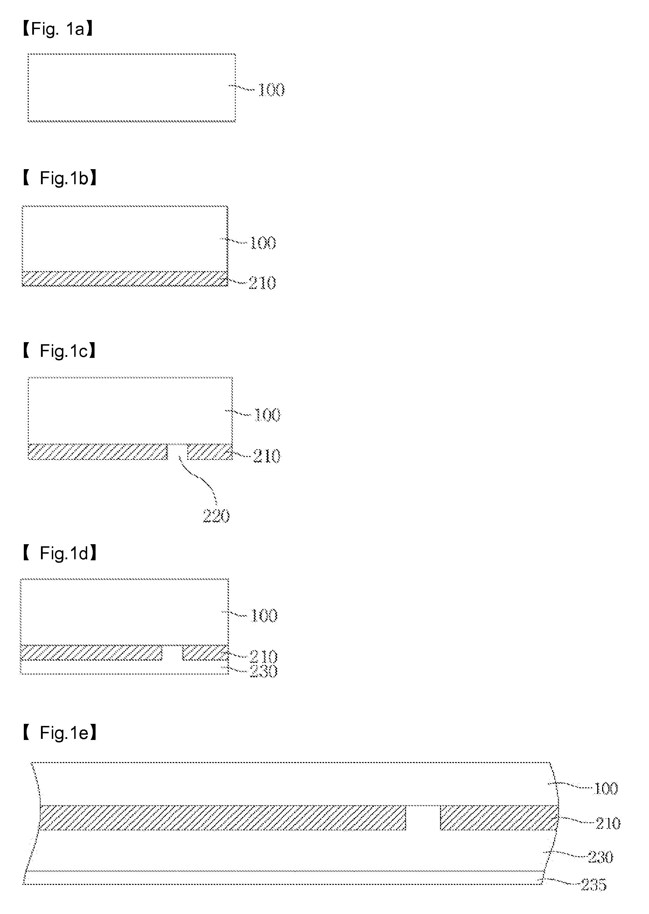

Figs. 1a to 1g show a method for manufacturing a photovoltaic device according to an embodiment of the present invention.

As shown in Fig. 1a, a substrate 100 is provided first. The substrate 100 may include an insulating transparent substrate and insulating opaque substrate. The insulating transparent substrate may be included in a p-i-n type photovoltaic device. The insulating opaque substrate may be included in an n-i-p type photovoltaic device. The p-i-n type photovoltaic device and n-i-p type photovoltaic device will be described later in detail.

As shown in Fig. 1b, a first electrode 210 is formed on the substrate 100. In the embodiment of the present invention, the first electrode 210 can be formed by a chemical vapor deposition (CVD) method and composed of transparent conductive oxide (TCO) such as Tin dioxide (SnO₂) or Zinc Oxide (ZnO).

As shown in Fig. 1c, a laser beam is irradiated onto the first electrode 210 or substrate 100 so that the first electrode 210 is scribed. As a result, a first separation groove 220 is formed on the first electrode 210. That is, since the first separation groove 220 penetrates the first electrode 210, the first electrodes 210 adjacent thereto are prevented from being short-circuited therebetween.

As shown in Fig. 1d, a first unit cell 230 is stacked on the first electrode 210 by a CVD method. Here, the first unit cell 230 includes a p-type semiconductor layer, an intrinsic semiconductor layer, and an n-type semiconductor layer. When source gas including silicon such as SiH₄ and doping gas including group 3 elements such as B₂H₆ are injected together into a reaction chamber in order to form the p-type semiconductor layer, the p-type semiconductor layer is formed by a CVD method. After that, the intrinsic semiconductor layer is formed on the p-type semiconductor layer by the CVD method after source gas including silicon is introduced into the reaction chamber. Doping gas including group 5 elements such as PH₃ and source gas including silicon are injected together, and then the n-type semiconductor layer is stacked on the intrinsic semiconductor layer by the CVD method. As a result, the p-type semiconductor layer, intrinsic semiconductor layer, and n-type semiconductor layer are sequentially stacked on the first electrode 210.

In the embodiment of the present invention, the p-type semiconductor layer, intrinsic semiconductor layer and n-type semiconductor layer may be sequentially stacked. Otherwise, the n-type semiconductor layer, intrinsic semiconductor layer and p-type semiconductor layer are sequentially stacked.

As shown in Fig. 1e, an intermediate reflector 235 is formed on the n-type semiconductor layer or p-type semiconductor layer of the first unit cell 230 through a plasma-enhanced chemical vapor deposition method. Non-silicon based source gas, n-type doping gas and source gas including silicon are introduced into the reaction chamber in order to form the intermediate reflector 235. The non-silicon based source gas includes oxygen source gas, carbon source gas, or nitrogen source gas.

A voltage alternately changing between a first frequency f1 and second frequency f2 is supplied to the reaction chamber so as to form the intermediate reflector 235. Here, a power source having the first frequency f1 and a power source having the second frequency f2 may supply a voltage alternately. Otherwise, a voltage changing between the first frequency f1 and second frequency f2 may be supplied by one power source.

A first voltage having the first frequency f1 is continuously supplied, and second voltage having the second frequency f2 higher than the first frequency f1 is alternately supplied.

As a result, the intermediate reflector 235 according to the embodiment of the present invention has a multilayer structure and includes a hydrogenated n-type nano-crystalline silicon oxide (n-nc-SiO:H), hydrogenated n-type nano-crystalline silicon carbide (n-nc-SiC:H), or hydrogenated n-type nano-crystalline silicon nitride (n-nc-SiN:H).

The intermediate reflector 235 will be described later in more detail.

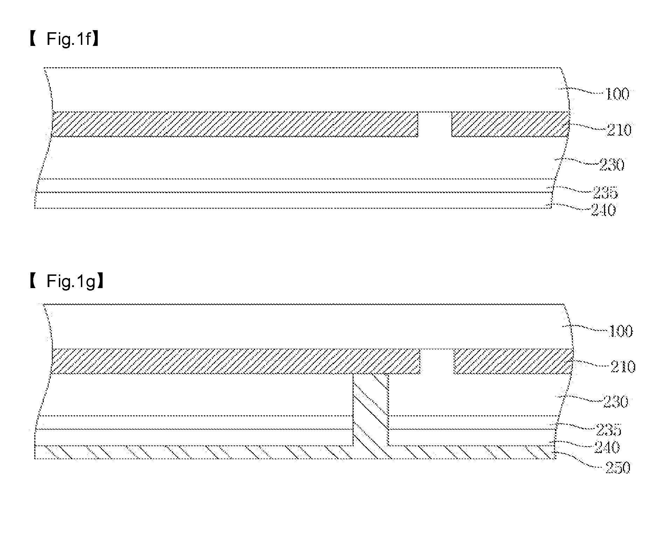

As shown in Fig. 1f, a second unit cell 240 including the p-type semiconductor layer, intrinsic semiconductor layer, and n-type semiconductor layer is formed on the intermediate reflector 235. If the first unit cell 230 includes the n-type semiconductor layer, intrinsic semiconductor layer, and p-type semiconductor layer which are stacked in the order listed, the second unit cell 240 also includes the n-type semiconductor layer, intrinsic semiconductor layer, and p-type semiconductor layer which are stacked in the order listed.

As shown in Fig. 1g, after a second separation groove 240 penetrating the first unit cell 230, intermediate reflector 235 and second unit cell 240 is formed, a second electrode 250 is formed on the second unit cell 240 such that the second separation groove is filled.

The embodiment of the present invention shown in Figs. 1a to 1g may include a double junction photovoltaic device composed of two unit cells or a triple junction photovoltaic device composed of three unit cells.

In the next place, a method for forming the intermediate reflector 235 will be described in detail with reference to the drawings.

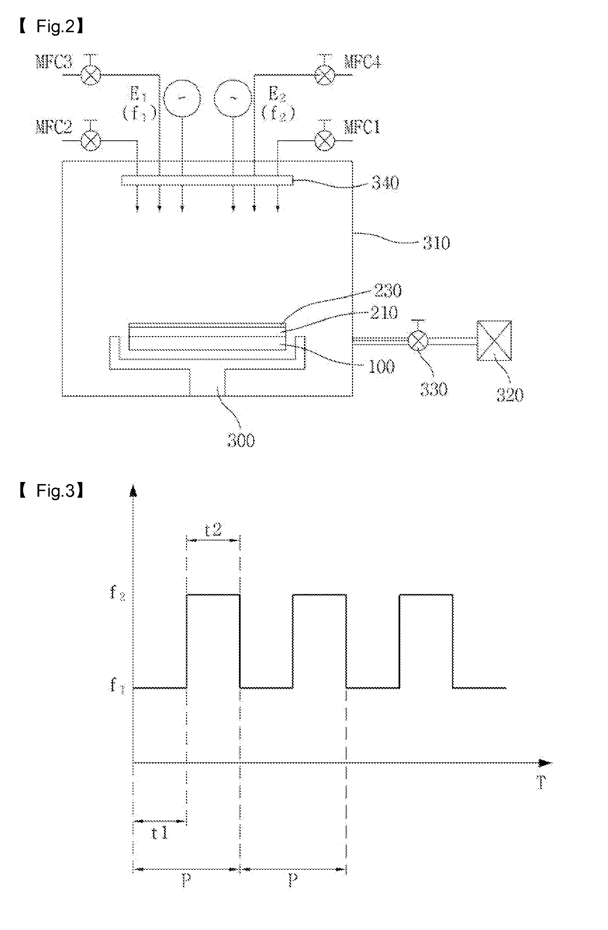

Fig. 2 shows a plasma-enhanced chemical vapor deposition apparatus for forming an intermediate reflector according to an embodiment of the present invention. As shown in Fig. 2, the substrate 100 on which the first electrode 210 and first unit cell 230 are formed is placed on a plate 300 functioning as an electrode.

The first unit cell 230 may include the p-type semiconductor layer, intrinsic semiconductor layer, and n-type semiconductor layer. Here, the n-type semiconductor layer may include a hydrogenated n-type nano-crystalline silicon (n-nc-Si:H), and the source gas for forming the n-type nano-crystalline silicon may include silane (SiH₄), hydrogen (H₂), or phosphine (PH₃).

After the n-type semiconductor layer including a hydrogenated n-type nano-crystalline silicon is formed, the non-silicon based source gas such as oxygen source gas, carbon source gas, or nitrogen source gas is introduced into the reaction chamber in a state where the flow rate, substrate temperature, and process pressure of the source gas introduced into the reaction chamber 310 are maintained.

Here, since the non-silicon based source gas is introduced into the reaction chamber 310 by keeping the flow rate, substrate temperature, and process pressure of the source gas in the reaction chamber 310, the n-type semiconductor layer of the first unit cell 230 and the intermediate reflector 235 can be formed in the same reaction chamber 310.

The method of forming the n-type semiconductor layer and intermediate reflector 235 in the same reaction chamber 310 can be applied not only to the p-i-n type photovoltaic device according to the embodiment of the present invention but also to the n-i-p type photovoltaic device.

As shown in Fig. 2, the source gases such as hydrogen (H₂), silane (SiH₄), or phosphine (PH₃) are introduced into the reaction chamber 310 through mass flow controllers MFC1, MFC2, and MFC3 and an electrode 340 having nozzles formed therein.

The non-silicon based source gas is introduced into the reaction chamber 310 through the mass flow controller (MFC4) and nozzle of the electrode 340. When the non-silicon based source gas is oxygen source gas, the oxygen source gas may include oxygen or carbon dioxide, and when the non-silicon based source gas is carbon source gas, the carbon source gas may include CH₄, C₂H₄, or C₂H₂, and when the non-silicon based source gas is nitrogen source gas, the nitrogen source gas may include NH₄, N₂O, or NO.

Here, an angle valve 330 is controlled to maintain the pressure of the reaction chamber 310 constant. When the pressure of the reaction chamber 310 is maintained constant, production of the silicon powder due to turbulence generation in the reaction chamber 310 is prevented and the deposition condition is maintained constant. The hydrogen is introduced in order to dilute the silane, and reduces Staebler-Wronski effect.

When the non-silicon based source gas is introduced with the source gases and when a first power source E1 and second power source E2 supply a first voltage and second voltage respectively, an electrical potential difference between the electrode 340 and plate 300 makes the gases in the reaction chamber 310 become in a plasma state and then be deposited on the hydrogenated n-type nano-crystalline silicon of the first unit cell 230. As a result, an intermediate reflector 235 is formed.

When oxygen source gas is introduced, the intermediate reflector 235 includes a hydrogenated n-type nano-crystalline silicon oxide (n-nc-SiO:H). When carbon source gas is introduced, the intermediate reflector 235 includes a hydrogenated n-type nano-crystalline silicon carbide (n-nc-SiC:H). When nitrogen source gas is introduced, the intermediate reflector 235 includes a hydrogenated n-type nano-crystalline silicon nitride (n-nc-SiN:H).

As such, since the intermediate reflector 235 includes the hydrogenated n-type nano-crystalline silicon based material similar to the hydrogenated n-type nano-crystalline silicon of a unit cell closest to the light incident side, the intermediate reflector 235 can be easily joined with the unit cell which is closest to the light incident side.

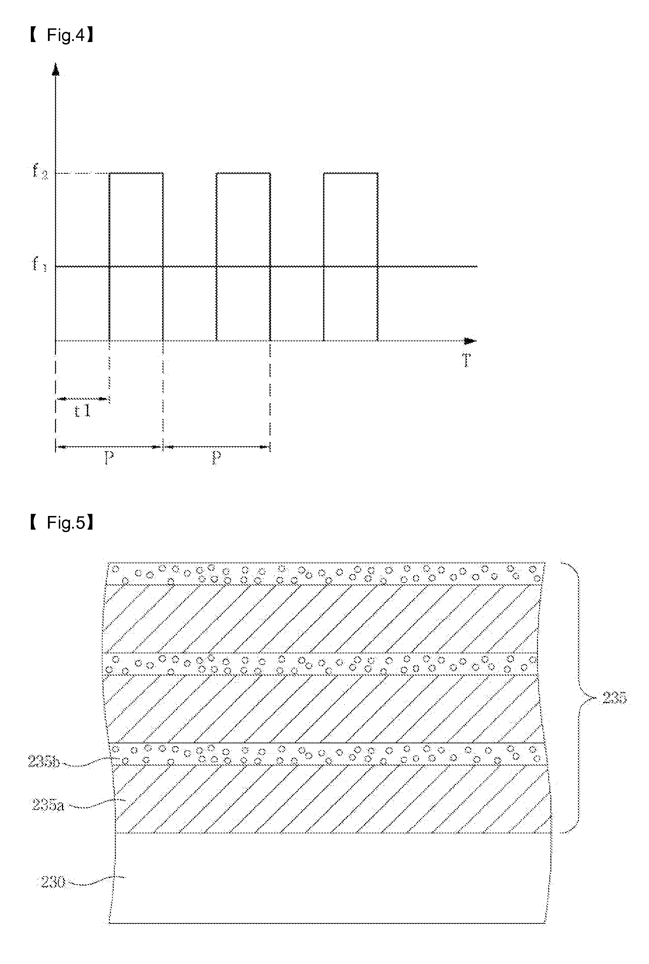

Figs. 3 and 4 show frequency variations of the first power source E1 and second power source E2 which are supplied to a reaction chamber 310 so as to form the intermediate reflector in accordance with the embodiment of the present invention.

In the embodiment of the present invention, the flow rates of hydrogen, silane and non-silicon based source gas which are introduced into the reaction chamber are constant in accordance with the elapsed deposition time T.

Here, as shown in Fig. 3, the first power source E1 and second power source E2 respectively supply the first voltage having the first frequency f1 and the second voltage having the second frequency f2 in an alternating manner. During one cycle derived from a sum of a duration time t1 for supplying the first voltage and a duration time t2 for supplying the second voltage, a ratio of a duration time t 1 for supplying the first voltage having the first frequency f1 to a duration time t2 for supplying the second voltage having the first frequency f2 is constant in accordance with the elapsed time. As a result, the intermediate reflector 235 includes at least one pair of a first sub-layer and second sub-layer, and a thickness ratio between the first sub-layer and second sub-layer in each of the pairs is constant.

As shown in Fig. 4, the first power source E1 continuously supplies a voltage having the first frequency f1 in accordance with the deposition time T. The second power source E2 discontinuously supplies a voltage having the second frequency f2. That is, the second power source E2 repeatedly supplies and stops supplying the voltage. Here, a ratio of a duration time t2 for supplying the second voltage having the second frequency f2 to a duration time for stopping supplying the second voltage having the second frequency f2, i.e., the duration time t1 for supplying only the first voltage is constant in each cycle. As a result, the intermediate reflector 235 includes at least one pair of a first sub-layer and second sub-layer, and a thickness ratio between the first sub-layer and second sub-layer in each of the pairs is constant.

The first sub-layer and second sub-layer of the intermediate reflector 235 will be described later in detail.

As shown in Figs. 3 and 4, when the first voltage and second voltage which have mutually different frequencies are supplied, as shown in Fig. 5, the intermediate reflector 235 including a plurality of sub-layers 235a and 235b is formed on the n-type semiconductor layer of the first unit cell 230.

As such, since the flow rate A of hydrogen and the flow rate B of silane remain constant in accordance with the elapsed deposition time T, the hydrogen dilution ratio, i.e., a ratio of the flow rate of hydrogen to the flow rate of silane is constant.

The sub-layers 235a and 235b of the intermediate reflector 235 is composed of a hydrogenated n-type nano-crystalline silicon based sub-layer 235b including crystalline silicon grains and a hydrogenated n-type nano-crystalline silicon based sub-layer 235a.

The hydrogenated n-type nano-crystalline silicon based material included in the plurality of sub-layers 235a and 235b is produced during a phase transition from an amorphous silicon based material to a crystalline silicon based material. Hereinafter, the hydrogenated n-type nano-crystalline silicon based sub-layer is referred to as the first sub-layer 235a, and the hydrogenated n-type nano-crystalline silicon based sub-layer including crystalline silicon grains is referred to as the second sub-layer 235b.

While crystallinity and deposition rate decrease as the frequency of the voltage supplied to the reaction chamber decreases, the crystallinity and deposition rate increase as the frequency of the voltage supplied to the reaction chamber increases. As a result, as shown in Fig. 3 to Fig. 4, the first sub-layer 235a, i.e., the hydrogenated n-type nano-crystalline silicon based sub-layer is formed during the supply of a voltage having the first frequency f1, and the second sub-layer 235b, i.e., the hydrogenated n-type nano-crystalline silicon based sub-layer including the crystalline silicon grains is formed during the supply of a voltage having the second frequency f2 higher than the first frequency f1.

The crystalline silicon grains of the second sub-layer 235a change a crystal volume fraction of the second sub-layer 235b, and the non-silicon based source gas changes a refractive index thereof. That is, the crystal volume fraction of the first sub-layer 235a formed at the duration time of supplying a voltage having the first frequency f1 is less than that of the second sub-layer 235b formed at the duration time of supplying a voltage having the second frequency f2 higher than the first frequency f1. The crystal volume fraction is a ratio of a volume occupied by crystal to the unit volume.

As a result, when a voltage having the first frequency f1 and a voltage having the second frequency f2 are supplied in an alternating manner as shown in Fig. 3, or when the voltage having the first frequency f1 is continuously supplied and the voltage having the second frequency f2 is repeatedly supplied and stopped being supplied as shown in Fig. 4, the first sub-layer 235a and second sub-layer 235b include a hydrogenated n-type nano-crystalline silicon oxide (n-nc-SiO:H), and the second sub-layer 235b includes the crystalline silicon grains surrounded by a hydrogenated n-type nano-crystalline silicon oxide.

When the non-silicon based source gas such as carbon source gas is supplied, the first sub-layer 235a and second sub-layer 235b include a hydrogenated n-type nano-crystalline silicon carbide (n-nc-SiC:H), and the second sub-layer 235b includes the crystalline silicon grains surrounded by a hydrogenated n-type nano-crystalline silicon carbide.

When the non-silicon based source gas such as nitrogen source gas is supplied, the first sub-layer 235a and second sub-layer 235b include a hydrogenated n-type nano-crystalline silicon nitride (n-nc-SiN:H), and the second sub-layer 235b includes the crystalline silicon grains surrounded by a hydrogenated n-type nano-crystalline silicon nitride.

As such, since the sub-layers 235a and 235b having the mutually different crystal volume fractions or mutually different refractive indexes are alternatively stacked, and each sub-layer 235a and 235b functions as a waveguide, it is possible to maximize the reflection of light by the intermediate reflector 235. Here, the second sub-layer 235b having the crystal volume fraction greater than that of the first sub-layer 235a, that is, the second sub-layer 235b having the crystalline silicon grains has a vertical electrical conductivity greater than that of the first sub-layer 235a. Accordingly, the intermediate reflector 235 allows an electric current to easily flow between the first unit cell 230 and the second unit cell 240.

The refractive index of the second sub-layer 235b including the crystalline silicon grains is greater than that of the first sub-layer 235a. Therefore, since the first sub-layer 235a having a refractive index lower than that of the second sub-layer 235b matches the refractive index with the unit cell closest to the light incident side, the first sub-layer 235a increases the reflection of light having a short wavelength which has high energy density, for example, light with a wavelength from 500nm to 700nm.

The diameter of the crystalline silicon grains of the second sub-layer 235b may be greater than or equal to 3nm and less than or equal to 10nm. Forming of the crystalline silicon grains having a diameter less than 3nm decreases the vertical electrical conductivity. When the diameter of the crystalline silicon grains is greater than 10nm, grain boundary surrounding the crystalline silicon grains has an excessively increased volume. Therefore, carrier recombination also increases and so efficiency may be decreased.

Meanwhile, as mentioned above, the hydrogen dilution ratio and pressure inside the chamber 310 are constant in the embodiments of the present invention. The flow rates of the hydrogen, silane and non-silicon based source gas which are supplied to the chamber 310 are constant. As a result, a possibility occurring of the turbulences of the hydrogen, silane and non-silicon based source gas in the chamber 310 is reduced, so that the film quality of the intermediate reflector 235 is improved.

Meanwhile, as described above, the plasma-enhanced chemical vapor deposition method is used instead of the photo-CVD in the embodiments of the present invention. Regarding the photo-CVD, not only it is not appropriate for manufacturing of the large area photovoltaic device, but also the UV light penetrating through a quartz window of the photo-CVD device decreases since a thin film is deposited on the quartz window as the deposition progresses.

As a result, since the deposition rate thereof gradually decreases, the thicknesses of the first sub-layer 235a and second sub-layer 235b gradually decrease. On the other hand, such weaknesses of the photo-CVD may be overcome by the plasma-enhanced chemical vapor deposition method.

In the plasma-enhanced chemical vapor deposition method used in the embodiment of the present invention, frequencies of voltages supplied from the first power source E1 and second power source E2 may be equal to or more than 13.56 MHz. When the frequency of the voltage is equal to or more than 13.56 MHz, the deposition rate of the intermediate reflector 235 is increased. When the second frequency f2 is equal to or more than 27.12 MHz, the deposition rate increases and the crystalline silicon grains can be easily formed.

In the embodiments of the present invention, the thickness of the intermediate reflector 235 may be greater than or equal to 30nm and less than or equal to 200 nm. When the thickness of the intermediate reflector 235 is greater than or equal to 30 nm, the refractive index match between the unit cell closest to the light incident side and the intermediate reflector 235 is obtained and the internal reflection can easily occur. When the thickness of the intermediate reflector 235 is less than or equal to 200 nm, the excessive light absorption by the intermediate reflector 235 itself caused by the thickness increase thereof is prevented.

The thicknesses of the first sub-layer 235a and second sub-layer 235b may be greater than or equal to 10nm and less than or equal to 50nm. When the thicknesses of the first sub-layer 235a and second sub-layer 235b are greater than or equal to 10nm, the refractive index is matched and the crystalline silicon grains can be sufficiently formed.

Further, when the thickness of the first sub-layer 235A235a or second sub-layer 235B235b is greater than 50nm, the number of sub-layers included in the intermediate reflector 235 may decrease due to the large thickness. As a result, the internal reflection by the intermediate reflector 235 may be decreased. Therefore, when the thicknesses of the first sub-layer 235a and second sub-layer 235b are less than or equal to 50nm, the appropriate number of sub-layers may be included in the intermediate reflector 235 and so the light can be easily reflected.

As mentioned above, the number of the sub-layers included in the intermediate reflector 235 can be greater than or equal to three in that the thickness of the intermediate reflector 235 is greater than or equal to 30nm and less than or equal to 200nm and the thicknesses of the first sub-layer 235a and second sub-layer 235b are greater than or equal to 10nm and less than or equal to 50nm.

Meanwhile, the refractive index of the intermediate reflector 235 including the first sub-layer 235a and second sub-layer 235b may be greater than or equal to 1.7 and less than or equal to 2.2. When the refractive index of the intermediate reflector 235 is greater than or equal to 1.7, the vertical electrical conductivity of the intermediate reflector 235 is increased and a fill factor (FF) of a multiple junction photovoltaic device is improved. As a result, the efficiency is increased. When the refractive index of the intermediate reflector 235 is less than or equal to 2.2, light of a wavelength from 500nm to 700nm is easily reflected and the short circuit current of the first unit cell 230 increases. As a result, the efficiency is increased.

The average content of the non-silicon based element contained in the intermediate reflector 235 from the non-silicon based source gas may be greater than or equal to 10 atomic % and less than or equal to 30 atomic %. In the embodiment of the present invention, the non-silicon based source gas may be oxygen, carbon, or nitrogen. When the average content of the non-silicon based element is greater than or equal to 10 atomic %, the refractive index match between the unit cell closest to the light incident side and the intermediate reflector 235 is achieved and the internal reflection can easily occur.

Further, when the average content of the non-silicon based element is unnecessarily large, the vertical electrical conductivity of the sub-layers may deteriorate since the crystal volume fraction thereof decreases. Therefore, in the embodiment of the present invention, when the average content of the non-silicon based element is less than or equal to 30 atomic %, the electrical conductivity is improved since the average crystal volume fraction of the intermediate reflector 235 is appropriately maintained and it prevents intermediate reflector 235 from getting amorphous.

The average hydrogen content of the intermediate reflector 235 may be greater than or equal to 10 atomic % and less than or equal to 25 atomic %. When the average hydrogen content of the intermediate reflector 235 is greater than or equal to 10 atomic %, the film quality of the intermediate reflector 235 is improved since the dangling bonds are passivated. When the average hydrogen content in the intermediate reflector 235 is unnecessarily large, the electrical conductivity of the intermediate reflector 235 decreases since the crystal volume fraction thereof becomes small. Therefore, when the average hydrogen content contained in the intermediate reflector 235 is less than or equal to 25 atomic %, the vertical electrical conductivity increases since it prevents the intermediate reflector 235 from getting amorphous caused by the decrease of the crystal volume fraction.

The average crystal volume fraction of the intermediate reflector 235 can be greater than or equal to 4% and less than or equal to 30%. When the average crystal volume fraction of the intermediate reflector 235 is greater than or equal to 4%, the tunnel junction property improves, and when the average crystal volume fraction of the intermediate reflector 235 is less than 30%, degradation of the refractive index matching property is prevented since the content of the non-silicon based material is maintained.

Since the intermediate reflector 235 according to the embodiment of the present invention includes an n-type nano-crystalline silicon having a good vertical electrical conductivity, it may be substituted for an n-type semiconductor layer of the unit cell of the side from which light is incident. For example, the photovoltaic device according to the embodiment of the present invention includes a first unit cell including a p-type semiconductor layer and an intrinsic semiconductor layer, the intermediate reflector 235, and a second unit cell including a p-type semiconductor layer, an intrinsic semiconductor layer, and an n-type semiconductor layer. When the intermediate reflector 235 is substituted for the n-type semiconductor layer of the unit cell of the side from which light is incident, it can reduce the manufacturing time and cost of the photovoltaic device.

In the case of the p-i-n type photovoltaic device on which light is incident through the first unit cell 230, the intermediate reflector 235 may replace the n-type semiconductor layer of the first unit cell 230. Regarding the n-i-p type photovoltaic device on which light is incident through the second unit cell 240, the intermediate reflector 235 may replace the n-type semiconductor layer of the second unit cell 240.

Although the p-i-n type photovoltaic device on which light is incident in the direction from the first unit cell 230 formed on the substrate 100 to the second unit cell 240 has been described in the embodiment of the present invention, the present invention may be applied to an n-i-p type photovoltaic device on which light is incident from the opposite side to the substrate 100, that is, in the direction from the second unit cell 240 to the first unit cell 230.

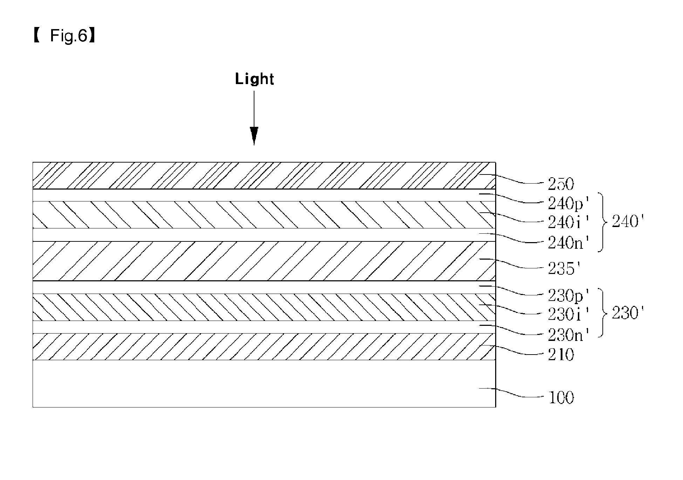

In other words, as shown in Fig. 6, regarding the n-i-p type photovoltaic device, light is incident from the opposite side to the substrate 100, and the first unit cell 230' having an n-type semiconductor layer 230n', an intrinsic semiconductor layer 230i', and a p-type semiconductor layer 230p' sequentially stacked therein is formed on the first electrode 210. The intermediate reflector 235' is formed on the first unit cell 230'. The second unit cell 240' having an n-type semiconductor layer 240n', an intrinsic semiconductor layer 240i', and a p-type semiconductor layer 240p' sequentially stacked therein is formed on the intermediate reflector 235'. The second electrode 250 is formed on the second unit cell 240'.

The intermediate reflector 235' is required to form a refractive index matching with the second unit cell 240' of the side from which light is incident, and the intermediate reflector 235' contacts with the n-type semiconductor layer of the second unit cell 240'. Therefore, after forming the p-type semiconductor layer of the first unit cell 230', the intermediate reflector 235' including n-type nano-crystalline silicon based material is formed. Here, the intermediate reflector 235 includes a plurality of sub-layers in accordance with the frequency of the applied voltage.

Meanwhile, the photovoltaic device according to the embodiments of the present invention includes the intermediate reflector 235 so as to improve the efficiency of a tandem structure including a plurality of the unit cells. It is possible to provide even better efficiency by controlling the electric currents of the plurality of the unit cells in addition to introducing the intermediate reflector 235.

In general, the operating temperature of the photovoltaic device is an important factor in designing current matching among the plurality of the unit cells of the photovoltaic device having a tandem structure.

For example, a photovoltaic device installed in a region having high temperature or strong ultraviolet radiation is designed such that short circuit current of the photovoltaic device is determined by the short circuit current of the unit cell which is closest to the light incident side among the unit cells of the photovoltaic device. This is because the photovoltaic device having its short circuit current determined by the short circuit current of the unit cell which is closest to the light incident side has low temperature coefficient (i.e., an efficiency degradation rate of the photovoltaic device according to temperature rise by 1 °C). That is, the temperature rise of the photovoltaic device has small influence on the efficiency degradation thereof.

On the other hand, a photovoltaic device installed in a region having low temperature or small amount of ultraviolet radiation is designed such that short circuit current of the photovoltaic device is determined by the short circuit current of the unit cell which is farthest from the light incident side among the unit cells of the photovoltaic device. Even though the photovoltaic device having its short circuit current determined by the short circuit current of the unit cell which is farthest from the light incident side has high temperature coefficient (i.e., an efficiency degradation rate of the photovoltaic device according to a temperature rise by 1 °C), it has low degradation ratio. Since the photovoltaic device installed in a low temperature region is relatively less affected by the temperature coefficient, the photovoltaic device is designed such that the short circuit current of the photovoltaic device is determined by the short circuit current of the unit cell which is farthest from the light incident side.

A rated output (efficiency) of the photovoltaic device designed in this manner is measured indoors under standard test conditions (hereinafter, referred to as STC). The set of STC consists of the followings.
AM 1.5 (AIR MASS 1.5)
Irradiance: 1000 W·m⁻²
Photovoltaic cell Temperature: 25 °C

However, when a photovoltaic device is installed outdoors, it happens that the temperature of the photovoltaic device is higher than 25 °C. In this case, due to the temperature coefficient of the photovoltaic device, the efficiency of the photovoltaic device becomes lower than the rated efficiency of the photovoltaic device measured under the STC.

That is, when the photovoltaic device is operating, most of light energy absorbed by the photovoltaic device is converted into heat energy. An actual operating temperature of the photovoltaic device hereby easily becomes higher than 25 °C, i.e., the photovoltaic cell temperature under the STC. Accordingly, the temperature coefficient of the photovoltaic device causes the efficiency of the photovoltaic device to be lower than the rated efficiency of the photovoltaic device measured under the STC.

Because of such problems, when current matching design in the photovoltaic device having a tandem structure is performed on the basis of 25 °C, i.e., the temperature of the photovoltaic device according to the STC without considering the actual operating temperature thereof in the external environment, the photovoltaic device may not achieve a desired efficiency.

Accordingly, current matching design of the photovoltaic device according to the embodiment of the present invention is performed under a nominal operating cell temperature obtained in a standard reference environment which is similar to the actual condition under which the photovoltaic device is installed. The set of standard reference environment includes the followings.
Tilt angle of photovoltaic device: 45° from the horizon
Total irradiance: 800 W·m⁻²
Circumstance temperature: 20 °C
Wind speed: 1m·s⁻¹
Electric load: none (open state)

The nominal operating cell temperature corresponds to a temperature at which the photovoltaic device mounted on an open rack operates under the standard reference environment. The photovoltaic device is used in a variety of actual environments. Therefore, when designing the current matching of the photovoltaic device having a tandem structure is performed under nominal operating cell temperature measured in the standard reference environment which is similar to the condition under the photovoltaic device is actually installed, it is possible to manufacture the photovoltaic device suitable for the actual installation environment. By controlling the thicknesses and optical band gaps of the i-type photoelectric conversion layers of the first unit cell 230' and second unit cell 240' such that the short circuit currents of the first unit cell 230' and the second unit cell 240' are controlled, the efficiency of the photovoltaic device may be enhanced.

For this reason, in the embodiment of the present invention, when the nominal operating cell temperature of the photovoltaic device is equal to or more than 35 degrees Celsius, the thickness and optical band gap of the i-type photoelectric conversion layer of one unit cell which is closest to the light incident side between the first unit cell 230' and second unit cell 240' is set such that the short circuit current of the one unit cell is equal to or less than that of the other unit cell. As a result, the short circuit current of the photovoltaic device according to the embodiment of the present invention is determined by the short circuit current of the unit cell which is closest to the light incident side.

As such, when the short circuit current of one unit cell which is closest to the light incident side is equal to or less than that of the other unit cell, the temperature coefficient becomes smaller. Therefore, although the actual temperature of the photovoltaic device becomes higher, electricity generation performance decrease due to the efficiency degradation is reduced. For example, when the photovoltaic device designed for making the short circuit current of one unit cell which is closest to the light incident side to be equal to or less than the short circuit current of the other unit cell is installed in a region having high temperature or strong ultraviolet rays of sunlight including intensive short wavelength rays in a blue-color range, the temperature coefficient is small. Therefore, although the actual temperature of the photovoltaic device becomes higher, the electricity generation performance decrease due to the efficiency degradation is reduced.

Contrary to this, when the nominal operating cell temperature of the photovoltaic device is less than and not equal to 35 degrees Celsius, the thicknesses and optical band gap of the i-type photoelectric conversion layer of one unit cell which is farthest from the light incident side between the first unit cell 230' and second unit cell 240' is set such that the short circuit current of the other unit cell which is closest to the light incident side is equal to or less than that of the one unit cell. In other words, when the nominal operating cell temperature of the photovoltaic device is less than and not equal to 35 degrees Celsius, the thickness and optical band gap of the i-type photoelectric conversion layer of one unit cell which is closest to the light incident side between the first unit cell 230' and second unit cell 240' is determined such that the short circuit current of the other unit cell is equal to or more than that of the one unit cell.

A resulting short circuit current of the photovoltaic device according to the embodiment of the present invention is hereby determined by the short circuit current of the unit cell which is farthest from the light incident side between the first unit cell and second unit cell. In this case, even though temperature coefficient of the photovoltaic device is high, degradation ratio of the photovoltaic device is reduced. Since the actual operating temperature of the photovoltaic device is relatively low, the electricity generation performance may be improved in that the performance improvement due to the low degradation ratio may overtake the performance deterioration due to the high temperature coefficient. Particularly, because the degradation rate in fill factor is small, the photovoltaic device has an excellent outdoor electricity generation performance in an environment having a circumference temperature lower than 25 °C, i.e., the STC.

As described in the embodiment, regarding the photovoltaic device of which current matching design is performed under the nominal operating cell temperature, the short circuit current of the photovoltaic device can be measured under the STC.

The foregoing embodiments and advantages are merely exemplary and are not to be construed as limiting the present invention. The present teaching can be readily applied to other types of apparatuses. The description of the foregoing embodiments is intended to be illustrative, and not to limit the scope of the claims. Many alternatives, modifications, and variations will be apparent to those skilled in the art. In the claims, means-plus-function clauses are intended to cover the structures described herein as performing the recited function and not only structural equivalents but also equivalent structures.

## Claims

1. A method for manufacturing a photovoltaic device, the method comprising:
forming a first electrode (210) on a substrate (100);
forming a first unit cell (230 and 230') on the first electrode (210), the first unit cell comprising an intrinsic semiconductor layer (230i');
forming an intermediate reflector (235 and 235') on the first unit cell (230 and 230');
forming a second unit cell (240 and 240') on the intermediate reflector (235 and 235'), the second unit cell comprising an intrinsic semiconductor layer (240i'); and
forming a second electrode (250) on the second unit cell (240 and 240'),
wherein the intermediate reflector (235 and 235') comprises a plurality of sub-layers stacked alternately by modulating the applied voltages in accordance with time, the applied voltages exciting plasma and having mutually different frequencies.

2. The method according to claim 1, wherein the applied voltages comprise both a first voltage having a first frequency and a second voltage having a second frequency higher than the first frequency, and
wherein the intermediate reflector (235 and 235') is formed by alternately supplying the first voltage and the second voltage.

3. The method according to claim 1, wherein the applied voltages comprise both a first voltage having a first frequency and a second voltage having a second frequency higher than the first frequency, and
wherein the intermediate reflector (235 and 235') is formed by continuously supplying the first voltage and by repeatedly supplying and stopping supplying the second voltage.

4. The method according to any one of claims 1, 2 or 3, wherein the intermediate reflector (235 and 235') is formed by introducing non-silicon based source gas with a constant flow rate.

5. The method according to claim 4, wherein the non-silicon based source gas comprises oxygen source gas, carbon source gas, or nitrogen source gas.

6. The method according to claim 5, wherein the oxygen source gas comprises oxygen or carbon dioxide, the carbon source gas comprises CH₄, C₂H₄, or C₂H₂, and the nitrogen source gas comprises NH₄, N₂O or NO.

7. The method according to any one of claims 1, 2 or 3, wherein, after forming an n-type semiconductor layer including a hydrogenated n-type nano-crystalline silicon of a unit cell which is closest to a light incident side between the first unit cell (230 and 230') and the second unit cell (240 and 240'),
non-silicon based source gas for forming the intermediate reflector (235 and 235') is introduced into a reaction chamber in a state where a flow rate, a substrate temperature, and a process pressure of source gas introduced into the reaction chamber for forming the n-type semiconductor layer are maintained.

8. The method according to any one of claims 1, 2 or 3, wherein, a flow rate of hydrogen and a flow rate of silane are constant in accordance with the elapsed deposition time during the formation of the intermediate reflector (235 and 235').

9. The method according to claim 2, wherein during one cycle derived from a sum of a duration time for supplying the first voltage and a duration time for supplying the second voltage,
a ratio of a duration time for supplying the first voltage to a duration time for supplying the second voltage is constant in accordance with the elapsed time.

10. The method according to claim 3, wherein during one cycle derived from a sum of a duration time for supplying the second voltage and a duration time for stopping supplying the second voltage,
a ratio of a duration time for supplying the second voltage to a duration time for stopping supplying the second voltage is constant in accordance with the elapsed time.

11. The method according to any one of claims 1, 2 or 3, wherein the intermediate reflector (235 and 235') is formed by a plasma-enhanced chemical vapor deposition method.

12. The method according to claim 2 or 3, wherein the first frequency and the second frequency are equal to or more than 13.56 MHz.

13. The method according to claim 2 or 3, wherein the second frequency higher than the first frequency is equal to or more than 27.12 MHz.

14. The method according to any one of claims 1, 2 or 3, wherein a unit cell which is closest to a light incident side between the first unit cell (230 and 230') and the second unit cell (240 and 240') comprises a p-type semiconductor layer and an intrinsic semiconductor layer, and
the intermediate reflector (235 and 235') is formed contacting with the intrinsic semiconductor layer of the unit cell which is closest to the light incident side.

15. A photovoltaic device comprising:
a substrate (100);
a first electrode (210) placed on the substrate (100);
a first unit cell (230 and 230') placed on the first electrode (210) and comprising an intrinsic semiconductor layer (230i');
an intermediate reflector (235 and 235') placed on the first unit cell (230 and 230');
a second unit cell (240 and 240') placed on the intermediate reflector (235 and 235') and comprising an intrinsic semiconductor layer (240i'); and
a second electrode (250) placed on the second unit cell (240 and 240'),
wherein the intermediate reflector (235 and 235') comprises a plurality of sub-layers stacked alternately and having different crystal volume fractions from each other by modulating the applied voltages in accordance with time, the applied voltages exciting plasma and having mutually different frequencies.

16. The photovoltaic device according to claim 15, wherein the intermediate reflector (235 and 235') includes a hydrogenated n-type nano-crystalline silicon oxide (n-nc-SiO:H), a hydrogenated n-type nano-crystalline silicon carbide (n-nc-SiC:H), or a hydrogenated n-type nano-crystalline silicon nitride (n-nc-SiN:H).

17. The photovoltaic device according to claim 15, wherein a unit cell which is closest to a light incident side between the first unit cell (230 and 230') and the second unit cell (240 and 240') comprises an n-type semiconductor layer including a hydrogenated n-type nano-crystalline silicon, and
the intermediate reflector (235 and 235') contacting with the n-type semiconductor layer includes an n-type nano-crystalline silicon based material.

18. The photovoltaic device according to any one of claims 15 to 17, wherein the sub-layers comprise a sub-layer comprising crystalline silicon grains.

19. The photovoltaic device according to claim 18, wherein a diameter of the crystalline silicon grains is equal to or more than 3 nm and equal to or less than 10 nm.

20. The photovoltaic device according to any one of claims 15 to 19, wherein a thickness of the intermediate reflector (235 and 235') is equal to or more than 30 nm and equal to or less than 200 nm.

21. The photovoltaic device according to any one of claims 15 to 20, wherein a thickness of each of the sub-layers is equal to or more than 10 nm and equal to or less than 50 nm.

22. The photovoltaic device according to any one of claims 15 to 21, wherein the intermediate reflector (235 and 235') comprises at least three sub-layers.

23. The photovoltaic device according to any one of claims 15 to 22, wherein a refractive index of the intermediate reflector (235 and 235') is equal to or more than 1.7 and equal to or less than 2.2 in a wavelength range from 500 nm to 700 nm.

24. The photovoltaic device according to any one of claims 15 to 23, wherein an average content of a non-silicon based element included in the intermediate reflector (235 and 235') is equal to or more than 10 atomic % and equal to or less than 30 atomic %.

25. The photovoltaic device according to any one of claims 15 to 24, wherein an average hydrogen content of the intermediate reflector (235 and 235') is equal to or more than 10 atomic % and equal to or less than 25 atomic %.

26. The photovoltaic device according to any one of claims 15 to 25, wherein an average crystal volume fraction of the intermediate reflector (235 and 235') is equal to or more than 4 % and equal to or less than 30 %.

27. The photovoltaic device according to any one of claims 15 to 26, wherein, when a nominal operating cell temperature is equal to or more than 35 degrees Celsius, a short circuit current of one unit cell which is closest to a light incident side between the first unit cell (230 and 230') and the second unit cell (240 and 240') is equal to or less than that of the other unit cell, or
when the nominal operating cell temperature is less than and not equal to 35 degrees Celsius, a short circuit current of one unit cell which is closest to a light incident side between the first unit cell (230 and 230') and the second unit cell (240 and 240') is equal to or more than that of the other unit cell.
